Europäisches Patentamt

European Patent Office

Office européen des brevets

(11) Publication number: **0 411 776 A1**

# EUROPEAN PATENT APPLICATION

(21) Application number: 90307533.1

(22) Date of filing: 10.07.90

(51) Int. Cl.⁵: **G01D 5/16, H03K 5/153**

(30) Priority: 04.08.89 US 389447

(43) Date of publication of application:
06.02.91 Bulletin 91/06

(84) Designated Contracting States:
DE GB IT

(71) Applicant: **DELCO ELECTRONICS
CORPORATION
700 East Firmin Street
Kokomo Indiana 46902(US)**

(72) Inventor: **Lippmann,Raymond
2426 Whitmore Lake Road
Ann Arbor, Michigan 48105(US)**
Inventor: **Chintyan, James Robert
2220 Old Hickory Boulevard
Davison, Michigan 48423(US)**
Inventor: **Schnars, Michael John
5055 Mohawk
Charleston, Michigan 48016(US)**

(74) Representative: **Denton, Michael John et al
Patent Section Vauxhall Motors Limited 1st
Floor Gideon House 26 Chapel Street
Luton Bedfordshire LU1 2SE(GB)**

(54) Sensor driver circuit.

(57) A driver circuit for a sensor (2) having an impedance that varies in relation to a parameter to be measured. The driver circuit provides an AC voltage pulse (1) to the sensor forcing a current through the sensor. The voltage at the sensor output can then be sampled (3) as a function of the impedance of the sensor, and therefore a function of the parameter to be measured. The circuit also negates any offset voltage between the ground for the sensor and the ground for the rest of the circuit.

FIG. 1

## SENSOR DRIVER CIRCUIT

This invention relates to a driver circuit for driving a sensor in which the impedance of the sensor varies in relation to a parameter to be measured.

Any exposed terminals or contacts of a sensor that has an electronic output which varies in relation to a specific parameter may corrode when there is a constant DC bias across them. This problem occurs in both sensors which have only on and off states (switches) and sensors which have outputs terminals come in contact with only a clean dry environment, the problem of corrosion is relatively minor. However, when terminals or contacts of the sensor are located in environments where they come in contact with corrosive or conductive fluids; for example, gas, alcohol, or water, part or all of the time, this problem of corrosion is greater. When a constant DC bias exists across these exposed terminals, they may corrode from plating, or separation of the fluid due to the presence of the electric charge.

A driver circuit in accordance with the present invention is characterised by the features specified in the characterising portion of Claim 1.

The present invention is directed to an improved driver circuit which reduces the corrosion of exposed terminals and contacts of a (variable impedance) sensor. The variable impedance sensor is a sensor that has an (output) impedance that varies in relation to a parameter to be measured. The driver circuit of the invention reduces corrosion in the terminals and contacts of the sensor by alternating the current through the sensor. The invention applies a voltage pulse to the sensor which establishes a current through the sensor, first in one direction, and then in the opposite direction, generating an output signal. By applying voltage to the sensor in pulses, the time during which any terminals or contacts in the sensor are biased is reduced, thus reducing the rate of corrosion of the terminals or contacts. By reversing the current through the sensor, the driver circuit cancels out any charge migration which may occur, thus reducing corrosion caused by electric separation of the fluid. Reversing the current through the sensor further reduces the rate of corrosion by causing plating to occur in both directions, spreading out the process over both terminals. The output signal of the sensor can be detected at one or more times during the application of the voltage pulse, as required by the sensor or the detection circuit. The detected signals are then used as a measure of the impedance of the sensor, and therefore a measurement of the parameter.

One embodiment of the invention uses a capacitor as a means to store a charge and reverse the current through the sensor. This implementation results in some unexpected benefits. In systems such as those used in vehicles, often the body of the vehicle is used as a common ground for all of the electrical parts. Such a system is advantageous because it reduces wiring requirements. However, when the body of the vehicle increases in size, the ground voltage in the body at one end of the vehicle may be different from the ground voltage at the other end of the vehicle. The ground at the rear, for example, is offset from the true ground at the front of the vehicle. This is because the current traveling from one end of the vehicle to the other, across the resistance of the vehicle body, causes a voltage drop proportional to the current. This voltage drop across the vehicle body can cause problems for sensitive gauges driven by sensors grounded at a point in the body where the ground is offset. The problem is compounded when the current traveling through the body of the vehicle is constantly varying, because this constantly changes the ground offset. The typical solution to this problem is to run a separate ground wire to the sensor.

The present invention allows a sensor to be grounded to an offset ground in a vehicle body without detracting from the accuracy of the sensor measurements. The capacitor which is used to store a charge and reverse the current through the sensor, also stores a charge equal to the offset voltage of the vehicle body. This allows the sensor to be driven by the same amount of current that it would receive if there was no ground offset. Thus, measurements can be taken which provide accurate readings of the parameter.

The present invention will now be described, by way of example, with reference to the following description, and the accompanying drawings, in which:-

Figure 1 is a circuit diagram of the invention, the driver circuit, connected to a (variable impedance) sensor;

Figure 2 comprises a circuit diagram for one implementation of the invention; and

Figure 3 shows the relation, in the implementation of the invention described in Figure 2, between the the oscillator voltage pulse, the one shot pulse, the sensor current, and the sensor voltage.

The invention pertains to providing a pulse from an AC pulse source to establish an AC current through a (variable impedance) sensor. The impedance of this sensor varies with a parameter to be measured. The current through the sensor allows output signals of the sensor to be detected as a measure of the impedance.

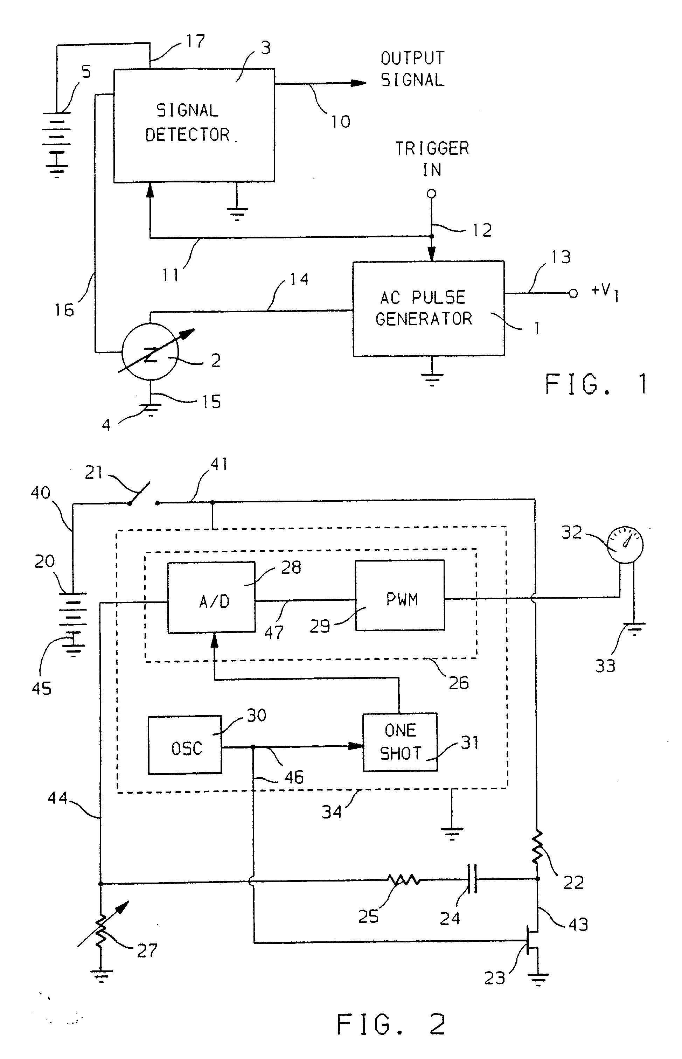

Referring to Figure 1, a signal from an external source, applied either randomly or periodically, as required by the system, triggers, through line 12, the AC pulse generator 1 to generate an AC pulse. This signal also triggers, through line 11, the signal detector 3, indicating that an AC pulse will be generated. Upon detection of the trigger signal, the AC pulse generator 1 then generates a voltage pulse, through line 14. This AC pulse contains first a positive DC component with respect to ground 4, and then a negative DC component with respect to ground 4. Alternatively, upon detection of the trigger signal, the AC pulse generator 1 may generate a voltage pulse, through line 14, which contains first a negative DC component with respect to ground 4, and then a positive DC component with respect to ground 4. For optimum performance, the AC pulse should have a net DC value of zero. If the AC pulse has a net DC value different than zero, the performance of the invention will be reduced in proportion to the net DC value of the pulse. This is because the cancellation of the charge migration is not complete if the net DC value of the AC pulse is other than zero. The AC pulse does not need to be of a specific shape. However the AC pulse must retain a similar shape for identical load impedances. In some cases the size of the voltage pulse may vary without hindering the performance of the circuit.

The (variable impedance) sensor 2 is connected to the AC pulse generator 1 through line 14. The sensor 2 is also grounded through line 15. The AC pulse establishes a current through the sensor 2. While current is established through the sensor 2, the sensor 2 generates an output signal, through line 16, which is a measure of the impedance of the sensor 2, and therefore a measure of the parameter sought to be determined. The signal detector 3 can detect the output signal, through line 16, and use the output signal for further processing or to drive a readable display, through line 10. A voltage source 5 powers the signal detector 3 through line 17, and the same or different voltage source powers the AC pulse generator through line 13.

Figure 2 describes a more detailed circuit application of the invention. Figure 2 shows a driver circuit, comprising components 22-25, and 30, which provides the AC pulse to the sensor 27. Figure 2 shows this driver circuit connected to the sensor 27, a voltage source 20, and a detection circuit 26 at the output of the sensor 27. The voltage source 20 provides power for the complete circuit. The voltage source 20 is connected to ground 33, through line 45, and connected to a switch 21, through line 40. The switch 21 controls the on-off state of the driver circuit. In the application of the invention to a vehicle, the switch 21 may represent the vehicle ignition switch. Line 41 supplies power to a signal detector and control 34, and power, through resistor 22, to a transistor 23, which supplies voltage pulses to the sensor 27.

An oscillator 30 serves as a square wave generator, sending the square waves through line 46. The oscillator frequency is determined by the frequency at which measurements of the parameter must be taken. One appropriate frequency range to use for driving sensors that measure fuel levels is 100-400 Hz, on a 0.1%-2% duty cycle. The lower the duty cycle, the less amount of time the sensor 27 is biased for a given frequency, and therefore the slower the rate of corrosion. The oscillator 30 sends square wave voltage pulses through line 46, which is connected to the rate of the transistor 23. The oscillator output controls the on-off state of the transistor 23. While the transistor 23 is off, a capacitor 24 charges. While the capacitor 24 is charging, the current will flow, in a first direction, through the sensor 27 and resistors 25 and 22. During this charging, the voltage across the sensor 27 rises to a maximum and then decreases exponentially. The resistor 25 and sensor 27 act as a voltage divider, line 44 being where the output of the voltage divider is measured. For any given voltage across the voltage divider, there is only one output voltage possible at line 44 for a given impedance of the sensor 27, and therefore one output voltage for a given measure of the parameter. While the capacitor 24 is charging, the output voltage of the sensor 27 can be sampled one or more times as necessary to get an accurate measure of the parameter.

The value of the capacitor 24 depends on the range of total resistances in the circuit, and must be such that it can sufficiently charge during application of the voltage pulse, and sufficiently discharge between voltage pulses. When the voltage output of the oscillator 30 turns transistor 23 on, current flows through line 43. At this point, the capacitor 24 discharges through both the transistor 23, which is connected to ground 33, and the voltage divider circuit, 25 and 27. While the capacitor 24 discharges, the current flowing through the sensor 27 is in the reverse direction of the current that was flowing through the sensor 27 when the capacitor 24 was charging. Also while the capacitor 24 discharges, the output voltage of the sensor 27, at line 44, can be sampled in the same manner as when the capacitor was charging if required. Output voltages sampled at this time will be negative with respect to the output voltages sampled when the capacitor 24 was charging.

Figure 2 also shows the output of the oscillator 30 serving as a trigger to a one shot 31 which controls when the signal detector will sample the output voltage (line 44) of the sensor 27. A small delay from the time the voltage pulse is applied to the time the pulse is sampled is desirable to avoid voltage spikes. The one-shot 31 provides this delay.

Both the task required of the sensor data and the type of sensor used dictate how the detection circuit 26 processes the output (line 44). If the sensor 27 is of the type that only requires one sample per voltage pulse, the detection circuit 26 may be designed in the same manner as the circuit shown. An A/D converter 28 is triggered by the one-shot 31. When triggered, the A/D converter 28 samples the sensor output voltage at line 44. The A/D converter 28 then produces a digital signal at line 47 corresponding to the analogue signal in line 44. The digital signal in line 47 can then be used by a display driver, here a pulse-width-modulator 29, to drive a readable display 32.

The circuit in Figure 2 also has the unexpected benefit of compensating for any offset voltages between the ground for the signal detector and control 34 and the ground for the sensor 27. The ground offset may occur if the circuit in Figure 2 is implemented in a vehicle which uses the body for a common ground when all of the components of the circuit, except the sensor, are mounted and grounded at one end of the vehicle, and the sensor 27 is be mounted and grounded at the other end of the vehicle. The only connecting wire would be line 44. Normally this would cause a problem if the ground voltages between the two ends of the vehicle are offset. But with this implementation of the circuit, the ground offset is not a problem. When the signal on line 46 biases the transistor 23 conductive, the capacitor 24 discharges any charge that it obtained when the transistor 23 was biased nonconductive. But the capacitor 24 then recharges to a voltage equal to the voltage difference between the ground of the sensor 27 and the ground of the transistor 23 (minus the slight drop across the transistor 23 which is virtually constant). With the transistor 23 turned off, if there was no charge on the capacitor 24, the voltage across the circuit of the sensor 27 and resistors 25 and 22 would be the supply voltage in line 41 minus the offset voltage. But the capacitor 24, with a charge voltage equal to the offset voltage, negates the offset voltage. So the sensor 27 is driven with the same current it would be driven with if there was no offset voltage between the ground for the sensor 27 and the ground for the rest of the circuit.

The capacitor 24 loses its charge quickly, so the measurement of the sensor impedance must be taken shortly after the transistor 23 is biased nonconductive. In order to measure the value before the capacitor 24 has lost more than 1% of its charge, the time after the transistor 23 is biased nonconductive to the time the data is sampled must be equal to or less than 0.01005 times the RC constant of the circuit when the transistor 23 is biased nonconductive (t = <0.01005RC).

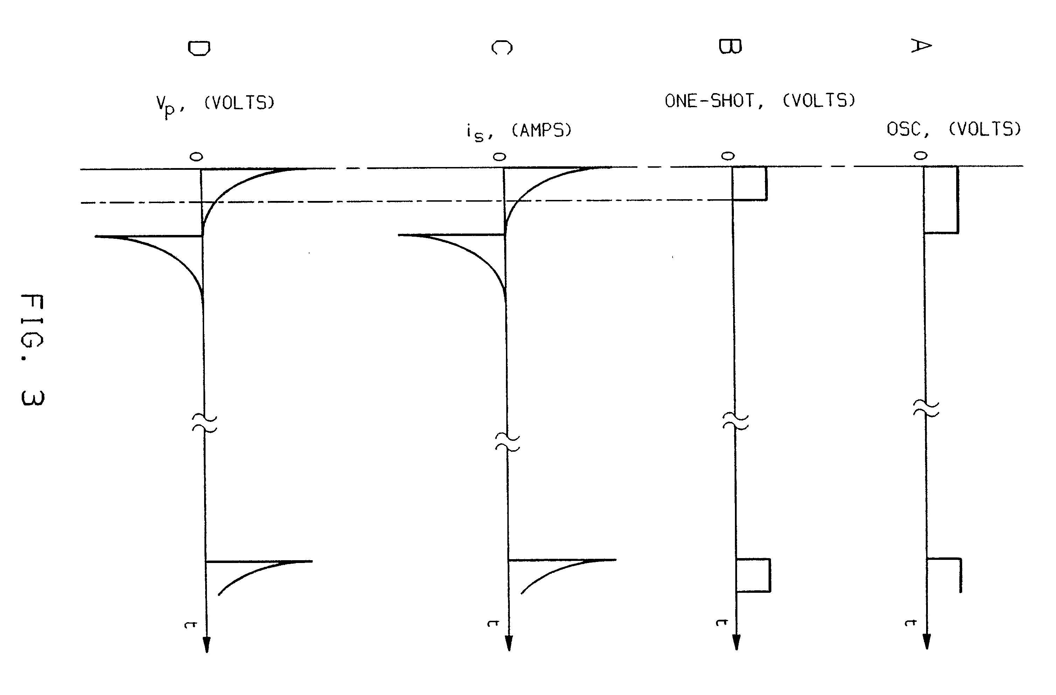

Figure 3 illustrates an example of the voltage and current relationships for the circuit in Figure 2. For the relationship shown, when the oscillator 30 goes high, current flows through the sensor 27 in a first direction. As can be seen, the current decreases exponentially. If the sensor 27 is a variable resistance element, a voltage appears across the sensor which varies in relation to the current through the sensor. At the falling edge of the one shot, the A/D converter 28 locks in the output voltage of the sensor 27. When oscillator 30 output goes low, the current flows through the sensor 27 in the opposite direction. Consequently, a voltage appears at the output of the sensor 27 in relation to the current.

The above embodiment is just one implementation of the invention. The invention does not need to appear as the above circuit. The relation between the oscillator output, the transistor on-off state, and the direction of current flow through the sensor may vary with different circuit applications of the invention.

## Claims

1. A driver circuit for a sensor (2) having an impedance which varies in relation to a parameter to be measured, comprising a detecting means (3) to detect an output signal of the sensor as a measure of the parameter; characterised by an applying means (1), including a source (5) of voltage, for applying a voltage pulse to the sensor (2) which establishes a current through the sensor first in one direction, and then in an opposite direction, to generate the output signal, the output signal having a value that is a measure of the impedance and therefore a measure of the parameter.

2. A driver circuit as claimed in Claim 1, wherein the applying means (22-25,30) applies a voltage pulse to the sensor (27) which establishes a current through the sensor in the first direction, and includes reversing means (23,24) for reversing the direction of the current through the sensor following application of the voltage pulse; and wherein the detecting means (28,29) detects the output signal of the sensor in relation to the voltage thereby developed across the sensor as a measure of the sensor impedance.

3. A driver circuit as claimed in Claim 2, wherein the reversing means comprises a charge storage means (24) connected between a voltage pulse source (23,30) and sensor (27) for storing a charge during application of the voltage pulse and thereafter releasing the stored charge to reverse the direction of the current through the sensor.

4. A driver circuit as claimed in Claim 3, wherein the charge storage means comprises a capacitor (24) connected between the voltage pulse source (23,30) and a resistor (25), the capacitor storing a charge during application of the voltage pulse, the resistor being connected between the capacitor and the sensor (27); and a discharge path (23) connected in parallel with the capacitor-resistor-sensor circuit, said discharge path providing a path for the capacitor to discharge after application of the voltage pulse, reversing the current through the sensor.

5. A driver circuit as claimed in Claim 4, wherein the sensor (27) is grounded to a ground (33) with an offset voltage and the capacitor (24) acts to negate the affect of the offset voltage at the sensor ground.

6. A driver circuit as claimed in Claim 4 or Claim 5, wherein the voltage pulse source comprises an intermittently conductive transistor (23).

7. A driver circuit as claimed in any one of Claims 2 to 6, additionally comprising a means (28,29) to drive a display (32) in relation to the parameter being measured using the detected output signals.

8. A driver circuit for a sensor (27) having an impedance which varies in relation to a parameter to be measured, the driver circuit being powered by a voltage source (20), comprising a square wave generator (30) set at a predetermined frequency; an intermittently conductive transistor (23), triggered by the square wave generator, providing a voltage pulse to a capacitor (24); the capacitor being connected between the transistor and a resistor (25), for storing a charge during application of the voltage pulse, and the resistor being connected between the capacitor and the sensor; a discharge path in parallel with the capacitor-resistor-sensor circuit, the discharge path providing a path for the capacitor to discharge after application of the voltage pulse, reversing the current through the sensor; a means (28-32) to detect an output signal of the sensor, as a measure of the parameter, while a current is being applied; and a means (28,29) to drive a readable display (32) in relation to the parameter being measured using the detected output signals.

9. A driver circuit as claimed in Claim 8, wherein the sensor (27) is grounded to a ground (33) with an offset voltage and the capacitor (24) acts to negate the affect of the offset voltage at the sensor ground.

FIG. 1

FIG. 2

FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | US-A-4793175 (FEDTER ET AL.)<br>* column 4, lines 23 - 34 *<br>* column 7, line 49 - column 8, line 56 * | 1, 2 | G01D5/16<br>H03K5/153 |
| Y | | 3-6, 8, 9 | |
| Y | MACHINE DESIGN.<br>vol. 41, no. 9, 17 April 1969, CLEVELAND US<br>pages 246 - 257; JACK H. STILL:<br>"FUNDAMENTALS OF PULSE TECHNOLOGY"<br>* figures 19D, 19E * | 3-6, 8, 9 | |
| X | US-A-4142148 (F.A. JOHANSSON)<br>* column 3, line 32 - column 4, line 38 * | 1, 2, 7 | |
| | | | **TECHNICAL FIELDS SEARCHED (Int. Cl.5 )**<br><br>G01D<br>H03K |

The present search report has been drawn up for all claims

| Place of search | Date of completion of the search | Examiner |
|---|---|---|
| THE HAGUE | 24 OCTOBER 1990 | LUT K. |

EPO FORM 1503 03.82 (P0401)